# EUROPEAN PATENT APPLICATION

(11) **EP 4 016 778 A1**
(43) Date of publication of application: **22.06.2022**
(21) Application number: 20852658.2
(22) Date of filing: 17.03.2020
(51) Int. Cl.: H02H 7/26, H02H 3/26, G01R 19/10

(54) **PROTECTION METHOD, APPARATUS AND SYSTEM FOR PSEUDO-BIPOLAR DIRECT-CURRENT POWER DISTRIBUTION NETWORK, AND DEVICE AND MEDIUM**

(30) Priority: 13.08.2019 CN 201910742476
(71) Applicant: NR ELECTRIC CO., LTD., Jiangning Nanjing, Jiangsu 211102 (CN); NR Engineering Co., Ltd., Nanjing, Jiangsu 211102 (CN)
(72) Inventor: LIU, Yongsheng, Nanjing, Jiangsu 211102 (CN); HOU, Wei, Nanjing, Jiangsu 211102 (CN); CHEN, Jun, Nanjing, Jiangsu 211102 (CN); WANG, Wenlong, Nanjing, Jiangsu 211102 (CN); LI, Yuqi, Nanjing, Jiangsu 211102 (CN)
(74) Representative: Kurig, Thomas
(86) International application number: PCT/CN2020/079753
(87) International publication number: WO 2021/027285

(57) **Abstract**

The present application provides a protection method, apparatus and system for a pseudo-bipolar direct-current power distribution network, and a device and a medium. The method comprises: detecting a transverse differential current value of a first direct-current switch of the pseudo-bipolar direct-current power distribution network, the transverse differential current value being an absolute value of a difference between a positive pole current amplitude and a negative pole current amplitude of the first direct-current switch; generating first transverse differential out-of-limit signals in response to a condition of the transverse differential current value being greater than a preset transverse differential out-of-limit threshold; detecting second transverse differential out-of-limit signals of a subordinate direct-current switch of the first direct-current switch; and determining that the fault of the first direct-current switch is an internal fault in response to a condition that the first transverse differential out-of-limit signals have been generated and the second transverse differential out-of-limit signals of the subordinate direct-current switch of the first direct-current switch are not found, and performing fault protection.

## Description

### Technical Field

The application relates to the technical field of relay protection of power distribution networks, in particular to a protection method, apparatus and system for a pseudo-bipolar direct-current power distribution network, a device and a medium.

### Background

With the development and application of new energy and new technologies, more and more distributed new energy sources need to be connected to a power distribution network, and the penetration rate of new energy sources in urban power distribution networks is getting higher and higher. Energy storage equipment used to stabilize power fluctuations in a power grid, charging piles used for charging electric vehicles, green charging and battery replacement stations and other new direct-current loads are also increasingly connected to urban distribution networks.

As a small and local power system, an urban low-voltage direct-current power distribution network has become a research focus in the field of urban distribution networks. Compared with an AC distribution network, the direct-current power distribution network can directly use distributed new energy sources, has better performance in transmission capacity, controllability and power supply quality improvement, and is a good access carrier of a large-scale distributed new energy grid, thus having become the development trend of future urban distribution networks.

At present, most converters in the direct-current power distribution network are modular multilevel converters, which mainly have three connection modes: pseudo-bipolar connection, true-bipolar connection and hybrid connection. In the pseudo-bipolar connection mode, a converter transformer is usually arranged between the converter and an alternating-current system for isolation between alternating-current and direct-current systems. A valve side of the converter transformer is generally equipped with a system grounding resistor, which forms an artificial neutral point by grounding with large resistance, which makes the direct-current system show symmetrical positive and negative polarities to the ground. However, when a unipolar grounding fault occurs in a pseudo-bipolar direct-current power distribution network system, the fault current does not increase obviously because of the large resistance of the system to the ground, so it is often difficult for a protection apparatus to judge and locate a fault point.

In the existing pseudo-bipolar direct-current power distribution system, insulation fault detection methods are often adopted to monitor the unipolar grounding fault. The insulation fault detection methods comprise balanced bridge method, unbalanced bridge method, alternating-current small signal injection method and portable leakage current detection method.

The inventor found that the balanced bridge method can only detect the grounding fault, but cannot determine a fault location, which needs to be checked manually after power failure. The unbalanced bridge method can measure insulation resistance, but resistors need to be installed on positive and negative buses, which lead to the reduction of the insulation level of a direct-current bus. The alternating-current small signal injection method calculates the grounding impedance according to the current amplitude and phase by injecting low-frequency alternating-current signals into positive and negative lines. However, because many direct-current power distribution systems contain micro-electromechanical devices, their anti-interference capacitance increases the capacitive current of the system, which leads to the failure of the alternating-current small signal injection method. The portable leakage current detection method allows free movement after a failure occurs, which is convenient and concise, but the compatibility of existing products is poor, which impedes its wide application.

### Summary

An embodiment of the application provides a method for protecting a pseudo-bipolar direct-current power distribution network, which comprises: detecting a transverse differential current value of a first direct-current switch of the pseudo-bipolar direct-current power distribution network, wherein the transverse differential current value is an absolute value of a difference between a positive pole current amplitude and a negative pole current amplitude of the first direct-current switch; generating a first transverse differential out-of-limit signal in response to a condition of the transverse differential current value being greater than a preset transverse differential out-of-limit threshold; detecting a second transverse differential out-of-limit signal of a subordinate direct-current switch of the first direct-current switch in the pseudo-bipolar direct-current power distribution network; and determining that a fault of the direct-current switch is an internal fault and performing fault protection in response to a condition that the first transverse differential out-of-limit signal has been generated and the second transverse differential out-of-limit signal of the subordinate direct-current switch of the first direct-current switch is not found.

As an aspect of this application, after generating the first transverse differential out-of-limit signals in response to a condition of the transverse differential current value being greater than the preset transverse differential out-of-limit threshold, the method further comprises: sending the first transverse differential out-of-limit signal to a direct-current switch protection apparatus adjacent to the first direct-current switch.

As an aspect of this application, the sending of the first transverse differential out-of-limit signal to the direct-current switch protection apparatus adjacent to the first direct-current switch comprises: sending the first transverse differential out-of-limit signal to the direct-current switch protection apparatus adjacent to the first direct-current switch through a platform for sharing data information.

As an aspect of this application, the detecting the second transverse differential out-of-limit signal of the subordinate direct-current switch of the first direct-current switch in the pseudo-bipolar direct-current power distribution network comprises: receiving the second transverse differential out-of-limit signal of the subordinate direct-current switch of the first direct-current switch in the pseudo-bipolar direct-current power distribution network through the platform for sharing data information.

As an aspect of this application, the preset transverse differential out-of-limit threshold is adjusted according to amplitude of a current flowing into the ground when a unipolar grounding fault occurs.

As an aspect of this application, the preset transverse differential out-of-limit threshold is adjusted according to 0.6-0.8 times of the amplitude of the current flowing into the ground when a unipolar grounding fault occurs.

As one aspect of the application, the method further comprises: adjusting the resistance value of a grounding resistor according to abnormal characteristics so as to adjust the transverse differential current value.

As an aspect of this application, the abnormal characteristics comprises: unbalanced positive and negative voltage amplitudes of the pseudo-bipolar direct-current power distribution network and/or an increased voltage to the ground at a valve side of a converter transformer of the pseudo-bipolar direct-current power distribution network when the unipolar grounding fault occurs.

As an aspect of this application, the adjusting the resistance value of the grounding resistor according to the abnormal characteristics so as to adjust the transverse differential current value comprises: reducing the resistance value of the grounding resistor according to the abnormal characteristics and a structure of the grounding resistor so as to adjust the transverse differential current value.

As an aspect of this application, the reducing the resistance value of the grounding resistor comprises: putting a small parallel resistor to the grounding resistor to reduce the resistance value of the grounding resistor.

As an aspect of this application, the reducing the resistance value of the grounding resistor comprises: turning on a lightning arrester connected in parallel with the grounding resistor to reduce the resistance value of the grounding resistor.

An embodiment of the application also provides a protection apparatus for a pseudo-bipolar direct-current power distribution network, which comprises a transverse differential current detection module, a transverse differential out-of-limit judgment module, a second transverse differential out-of-limit receiving module, an internal fault protection module and an external fault protection module, wherein the transverse differential current detection module detects a transverse differential current value of a first direct-current switch of the pseudo-bipolar direct-current power distribution network, and the transverse differential current value is an absolute value of a difference between a positive pole current amplitude and a negative pole current amplitude of the direct-current switch; the transverse differential out-of-limit judgment module generates a first transverse differential out-of-limit signal in response to a condition of the transverse differential current value being greater than a preset transverse differential out-of-limit threshold; the second transverse differential out-of-limit receiving module detects a second transverse differential out-of-limit signal of a subordinate direct-current switch of the first direct-current switch in the pseudo-bipolar direct-current power distribution network; and the internal fault protection module determines that a fault of the first direct-current switch is an internal fault and performs fault protection in response to a condition that the first transverse differential out-of-limit signal has been generated and the second transverse differential out-of-limit signal of the subordinate direct-current switch of the first direct-current switch is not found.

As an aspect of the application, the apparatus further comprises a grounding resistance adjusting module, which adjusts the resistance value of a grounding resistor according to abnormal characteristics so as to adjust the transverse differential current value.

An embodiment of the application also provides a protection system for a pseudo-bipolar direct-current power distribution network, which comprises the protection apparatus and a platform for sharing data information, wherein the platform for sharing data information communicates with a plurality of the protection apparatuses, and sends and receives the transverse difference out-of-limit signal.

An embodiment of the application also provides an electronic device, which comprises a memory, a processor and a computer program stored in the memory and capable of running on the processor, and is characterized in that when the program is executed by the processor, the processor is caused to execute the above method.

An embodiment of the application also provides a computer-readable storage medium on which a computer program is stored, and the computer-readable storage medium is characterized in that when the computer program is executed by a processor, the processor is caused to execute the above method.

According to the technical solution provided by the embodiments of the application, when a unipolar grounding fault occurs in the pseudo-bipolar direct-current power distribution network, by means of the unbalanced amplitudes of currents flowing through a fault pole and a non-fault pole, the protection apparatus uses the transverse differential current as the basis for fault judgment to judge a fault area, thereby realizing the selectivity of protection judgment, effectively improving the reliability of protection judgment and providing favorable conditions for fault isolation and recovery.

### Brief Description of the Drawings

In order to explain the technical solution in the embodiments of the application more clearly, the drawings used in the description of the embodiments will be briefly introduced below. Obviously, the drawings in the following description are only some embodiments of the application, and for those of ordinarily skilled in the field, other drawings can be obtained according to these drawings without creative labor.
Fig. 1 is a diagram of a typical architecture of a pseudo-bipolar direct-current power distribution network provided by an embodiment of the application;
Fig. 2 is a flow chart of a method for protecting a pseudo-bipolar direct-current power distribution network provided by an embodiment of the application;
Fig. 3 is a flow chart of a method for protecting a pseudo-bipolar direct-current power distribution network provided by another embodiment of the application;
Fig. 4 is a diagram of an electronic grounding resistor provided by an embodiment of the application;
Fig. 5 is a diagram of a small parallel resistor type grounding resistor provided by an embodiment of the application;
Fig. 6 is a diagram of a parallel lightning arrester type grounding resistor provided by an embodiment of the application;
Fig. 7 is a composition diagram of a protection apparatus for a pseudo-bipolar direct-current power distribution network provided by an embodiment of this application;
Fig. 8 is a composition diagram of a protection apparatus for a pseudo-bipolar direct-current power distribution network provided by another embodiment of this application; and
Fig. 9 is a composition diagram of a protection system for a pseudo-bipolar direct-current power distribution network provided by an embodiment of this application.

### Detailed Description of Embodiments

In order to make the purpose, technical solution and advantages of the embodiments of the application clearer, the specific implementations of the technical solution of the application will be clearly described in further detail below with reference to the drawings and embodiments. However, the specific implementations and embodiments described below are merely for the purpose of illustration, and are not a limitation of the application. They only cover some embodiments of the application, but not all embodiments. Other embodiments obtained by those skilled in the art based on various changes of the application also fall within the scope of protection of the application.

It should be understood that the terms "first", "second", "third" and "fourth" in the claims, specification and drawings of the application are used to distinguish different objects, but not to describe a specific order. As used in the specification and claims of the application, the terms "comprise" and "include" indicate the presence of the described features, integers, steps, operations, elements and/or components, but do not exclude the presence or addition of one or more other features, integers, steps, operations, elements, components and/or groups thereof.

It should also be understood that the terminology used in this application specification is only for the purpose of describing specific embodiments, and is not intended to limit this application. As used in the specification and claims of this application, the singular forms "a", "an" and "the" are intended to include the plural forms unless otherwise clearly indicated in the context. It should be further understood that the term "and/or" used in the specification and claims of this application refers to any combination and all possible combinations of one or more of the items listed in association, and includes these combinations.

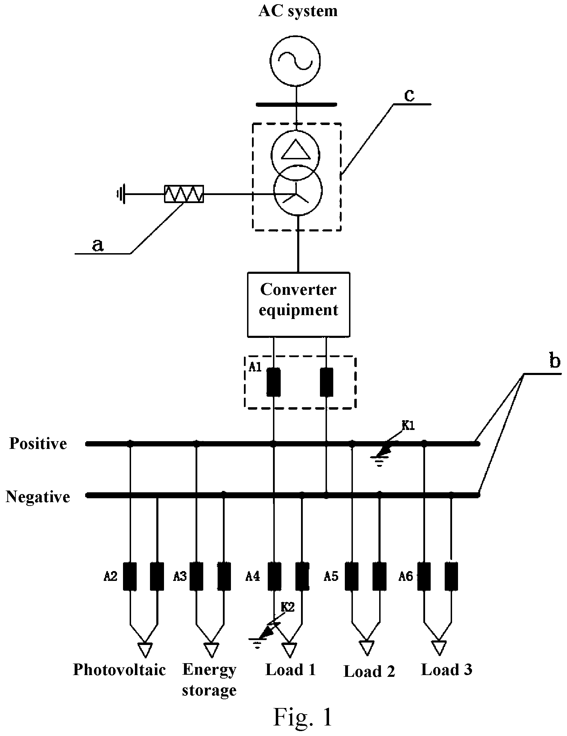

Fig. 1 is a diagram of a typical architecture of a pseudo-bipolar direct-current power distribution network provided by an embodiment of the application.

As shown in Fig. 1, the normal operating voltage of the pseudo-bipolar direct-current power distribution network is ±10 kV. In the figure, a is a grounding resistor, b is a direct-current bus, c is a converter transformer, A1 is a bus direct-current switch, and A2, A3, A4, A5 and A6 are all subordinate switches of the bus direct-current switch A1. Each direct-current switch is provided with a protection apparatus.

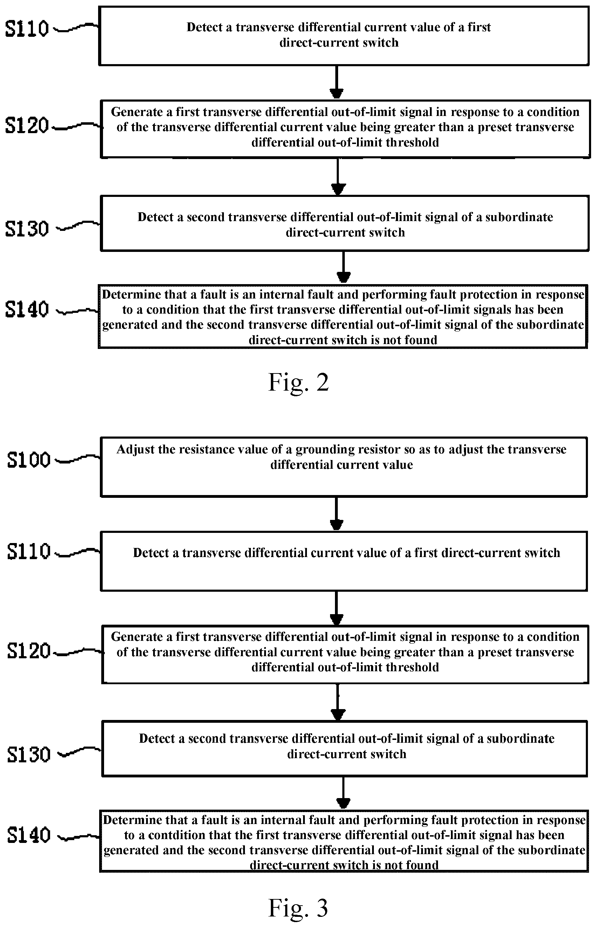

Fig. 2 is a flow chart of a method for protecting a pseudo-bipolar direct-current power distribution network provided by an embodiment of the application, and the method comprises the following steps.

In step S110, a transverse differential current value of a first direct-current switch of the pseudo-bipolar direct-current power distribution network is detected, wherein the transverse differential current value is an absolute value of a difference between a positive pole current amplitude and a negative pole current amplitude of the first direct-current switch.

The amplitudes of currents flowing through the positive and negative switches are detected and then subtraction is conducted to obtain the absolute value, so that the transverse differential current value is calculated. For the pseudo-bipolar direct-current power distribution network system, the transverse differential current value detected by a protection apparatus is almost zero under normal operation or an interpolar short circuit fault. However, when a unipolar grounding fault occurs, the amplitudes of currents flowing through a fault pole and a non-fault pole are unbalanced, and the transverse differential current value is the value of current flowing into the ground of a direct-current system.

In step S120, a first transverse differential out-of-limit signal is generated in response to a condition of the transverse differential current value being greater than a preset transverse differential out-of-limit threshold. The preset transverse differential out-of-limit threshold is adjusted according to the amplitude of current flowing into the ground when the unipolar grounding fault occurs, preferably, but not limited to 0.6-0.8 times of the amplitude of current.

The first transverse differential out-of-limit signal is generated if the transverse differential current value is greater than the preset transverse differential out-of-limit threshold. The first transverse differential out-of-limit signal is sent to a direct-current switch protection apparatus adjacent to the first direct-current switch.

In step S130, a second transverse differential out-of-limit signal of a subordinate direct-current switch of the first direct-current switch in the pseudo-bipolar direct-current power distribution network is detected.

In this embodiment, the second transverse differential out-of-limit signal of the subordinate direct-current switch of the first direct-current switch is received through, but not limited to, a data sharing platform. The second transverse differential out-of-limit signal is generated when a transverse differential current value of the subordinate direct-current switch of the first direct-current switch is greater than a preset second transverse differential out-of-limit threshold. The transverse differential current value of the subordinate direct-current switch is an absolute value of a difference between a positive pole current amplitude and a negative pole current amplitude of the subordinate direct-current switch.

In step S140, it is determined that a fault of the first direct-current switch is an internal fault and fault protection is performed in response to a condition that the first transverse differential out-of-limit signal has been generated and the second transverse differential out-of-limit signal of the subordinate direct-current switch of the first direct-current switch is not found.

The protection apparatus of each of the direct-current switches detects whether or not the first transverse differential out-of-limit signal of the direct-current switch is generated and whether or not the second transverse differential out-of-limit signal of the subordinate direct-current switch is detected. According to the judgment principle of transverse differential network protection, if there is only the first transverse differential out-of-limit signal but no second transverse differential out-of-limit signal of the subordinate direct-current switch, the fault of the direct-current switch is judged as an internal fault, and the internal fault is isolated and protected. According to the specific situation, the internal fault can be isolated and protected in, but not limited to, a delayed manner.

As shown in Fig. 1, if a fault occurs at K1, that is, a unipolar grounding fault of the bus occurs, the voltage between the positive pole and the ground drops to 0, and the voltage between the negative pole and the ground rises to -20 kV. Abnormal characteristics such as unbalanced amplitudes of positive and negative voltages, and an increased voltage to the ground at a valve side of a converter transformer appear, and the resistance value of the grounding resistor is decreased. The protection apparatus of the switch A1 on the bus detects the transverse differential current value, which is greater than the transverse differential out-of-limit threshold. However, the protection apparatuses of other switches A2, A3, A4, A5 and A6 on the same bus do not detect the out-of-limit transverse differential current value, and the second transverse differential out-of-limit signal is not generated. Therefore, the protection apparatus of the direct-current switch A1 determines that the fault is an internal fault. The switch A1 acts to clear the fault, and the fault will be completely isolated by jumping A2, A3, A4, A5 and A6 in parallel.

According to the judgment principle of transverse differential network protection, if there is the first transverse differential out-of-limit signal and the second transverse differential out-of-limit signal of the subordinate direct-current switch is detected, the fault of the direct-current switch is determined as an external fault, and the external fault is isolated and protected. According to the specific situation, the internal fault can be isolated and protected in, but not limited to, a delayed manner.

As shown in Fig. 1, if a fault occurs at K2, that is, a unipolar grounding fault occurs, the voltage between the positive pole and the ground drops to 0, and the voltage between the negative pole and the ground rises to -20 kV. The resistance value of the grounding resistor is decreased due to the abnormal characteristics of the system. The protection apparatuses of the direct-current switches A1 and A4 on the bus all detect the transverse differential current value larger than the transverse differential threshold, while the protection apparatuses of the other switches A2, A3, A5 and A6 do not detect the transverse differential current value larger than the transverse differential threshold.

Therefore, the protection apparatus of the direct-current switch A1 generates the first transverse differential out-of-limit signal and detects the second transverse differential out-of-limit signal transmitted from the subordinate switch A4, so the fault is determined as an external fault.

The protection apparatus of the direct-current switch A4 generates the first transverse differential out-of-limit signal, and the detected second transverse differential out-of-limit signal transmitted from the direct-current switch A1 does not belong to the second transverse differential out-of-limit signal of its subordinate switch, so it is determined that the fault is an internal fault, and the switch A4 acts to clear the fault.

According to the technical solution provided by the embodiment, when a unipolar grounding fault occurs in the pseudo-bipolar direct-current power distribution network, by means of the unbalanced amplitudes of currents flowing through a fault pole and a non-fault pole, the protection apparatus uses the transverse differential current as the basis for fault judgment to judge a fault area, thereby realizing the selectivity of protection judgment, effectively improving the reliability of protection judgment and providing favorable conditions for fault isolation and recovery.

Fig. 3 is a flow chart of a method for protecting a pseudo-bipolar direct-current power distribution network provided by another embodiment of the application, and the method comprises the following steps.

In step S100, the resistance value of the grounding resistor is adjusted according to the abnormal characteristics so as to adjust the transverse differential current value.

When a unipolar grounding fault occurs, the positive pole current of the first direct-current switch is equal to the sum of the load current and the current flowing into the ground, and the negative pole current is equal to the load current, so the transverse differential current value is approximately equal to the current flowing into the ground.

The current flowing into the ground depends on the value of grounding resistance. If the grounding resistance is too high, the current flowing into the ground will be very small and hard to detect. Therefore, it is possible to detect the resistance value of the grounding resistor of the pseudo-bipolar direct-current power distribution network when the unipolar grounding fault occurs, and the transverse differential current value can be adjusted by adjusting the magnitude of grounding resistance.

That is to say, when the abnormal characteristics such as unbalanced amplitudes of positive and negative voltages and an increased voltage to the ground at the valve side of the converter transformer appear, it is determined that there is a unipolar grounding fault, and the resistance value of the grounding resistor is adjusted at this point to adjust the transverse differential current value.

Specifically, according to the abnormal characteristics and the structure of the grounding resistor, the resistance value of the grounding resistor is reduced to adjust and increase the transverse differential current value, which facilitates detection and control.

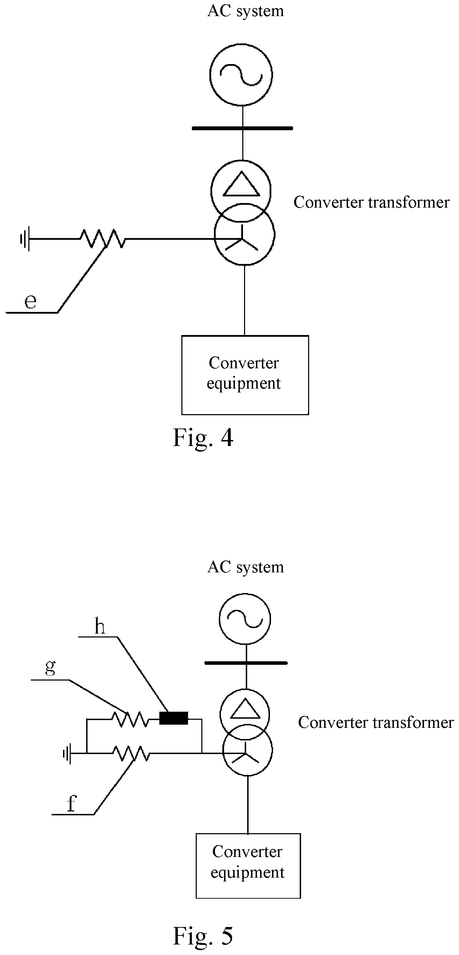

As shown in Fig. 4, if the grounding resistor is an electronic grounding resistor e, according to the abnormal characteristics of the system, after the fault is determined as a unipolar grounding fault, a resistance adjustment command is sent to the electronic grounding resistor e, and the resistance value of the electronic grounding resistor e can be statically adjusted according to a set target resistance value or dynamically adjusted according to voltage imbalance.

As shown in Fig. 5, a small parallel resistor type grounding resistor is adopted, f is the grounding resistor, g is a small parallel resistor, and h is a small resistor input switch. According to the abnormal characteristics of the system, after the fault is a determined as unipolar grounding fault, a closing command is sent to the small resistance input switch h, and the small parallel resistor g is put into operation. Finally, the grounding resistor consists of the grounding resistor f and the small parallel resistor g which are connected in parallel, which reduces the resistance value of the grounding resistor.

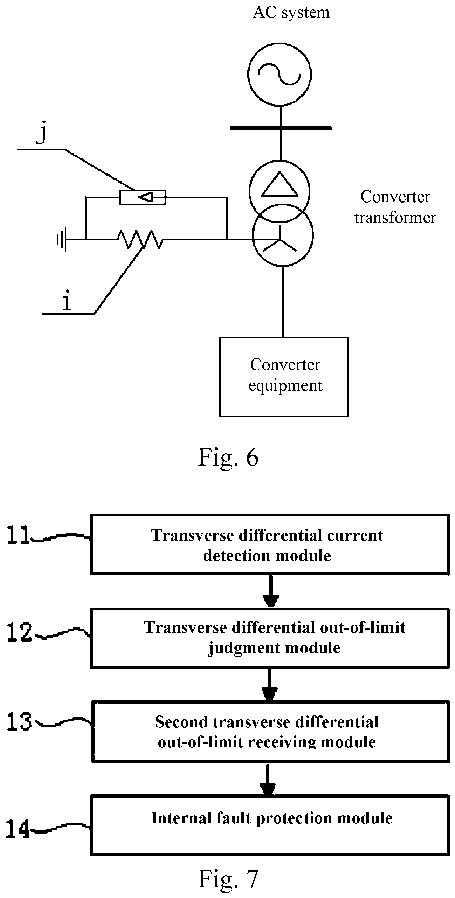

As shown in Fig. 6, if a parallel lightning arrester type grounding resistor is adopted, a lightning arrester j connected in parallel with the grounding resistor i will be turned on automatically due to the rise of the voltage to the ground on the valve side of the converter transformer, thus reducing the system resistance to the ground.

In step S110, a transverse differential current value of a first direct-current switch of the pseudo-bipolar direct-current power distribution network is detected, wherein the transverse differential current value is an absolute value of a difference between a positive pole current amplitude and a negative pole current amplitude of the first direct-current switch.

In step S120, a first transverse differential out-of-limit signal is generated in response to the transverse differential current value being greater than a preset transverse differential out-of-limit threshold.

In step S130, a second transverse differential out-of-limit signal of a subordinate direct-current switch of the first direct-current switch in the pseudo-bipolar direct-current power distribution network is detected.

In step S140, it is determined that a fault of the first direct-current switch is an internal fault and fault protection is performed in response to a condition that the first transverse differential out-of-limit signal has been generated and the second transverse differential out-of-limit signal of the subordinate direct-current switch of the first direct-current switch is not found.

In this embodiment, steps S110, S120, S130 and S140 are the same as those in the above embodiment, and will not be described again.

According to the technical solution provided by the embodiment, when a unipolar grounding fault occurs in the pseudo-bipolar direct-current power distribution network, by reducing the grounding resistance at the valve side of the converter transformer, the fault current of the direct-current system is increased, the sensitivity of protection judgment is improved, and the possibility of protection misjudgment caused by small fault current is prevented; and by means of the unbalanced amplitudes of currents flowing through a fault pole and a non-fault pole, the protection apparatus uses the transverse differential current as the basis for fault judgment to judge a fault area, thereby realizing the selectivity of protection judgment, effectively improving the reliability of protection judgment and providing favorable conditions for fault isolation and recovery.

Electronic device comprises a memory, a processor, and a computer program stored in the memory and capable of running on the processor. When the program is executed by the processor, the processor is caused to execute the above method.

A computer-readable storage medium has a computer program stored thereon, which, when executed by a processor, causes the processor to execute the method described above.

Fig. 7 is a composition diagram of a protection apparatus for a pseudo-bipolar direct-current power distribution network provided by an embodiment of this application. The protection apparatus comprises a transverse differential current detection module 11, a transverse differential out-of-limit judgment module 12, a second transverse differential out-of-limit receiving module 13, and an internal fault protection module 14.

The transverse differential current detection module 11 detects a transverse differential current value of a first direct-current switch of the pseudo-bipolar direct-current power distribution network, and the transverse differential current value is an absolute value of a difference between a positive pole current amplitude and a negative pole current amplitude of the direct-current switch; the transverse differential out-of-limit judgment module 12 generates a first transverse differential out-of-limit signal in response to the transverse differential current value being greater than a preset transverse differential out-of-limit threshold; the second transverse differential out-of-limit receiving module 13 receives second transverse differential out-of-limit signals of other protection apparatuses; and the internal fault protection module 14 determines that a fault of the first direct-current switch is an internal fault and performs fault protection in response to a condition that the first transverse differential out-of-limit signal has been generated and the second transverse differential out-of-limit signal of the subordinate direct-current switch of the first direct-current switch is not found.

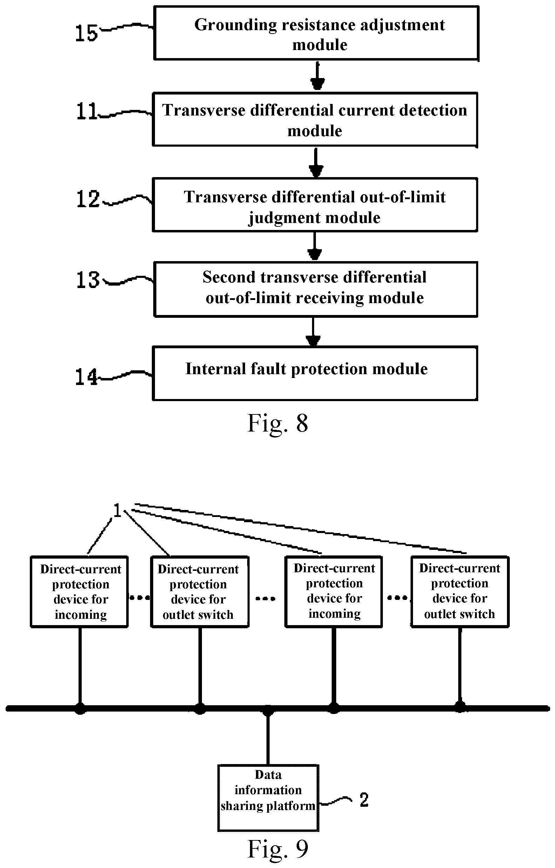

Fig. 8 is a composition diagram of a protection apparatus for a pseudo-bipolar direct-current power distribution network provided by another embodiment of this application. The protection apparatus comprises a transverse differential current detection module 11, a transverse differential out-of-limit judgment module 12, a second transverse differential out-of-limit receiving module 13, an internal fault protection module 14, and a grounding resistance adjustment module 15.

The grounding resistance adjustment module 15 adjusts the resistance value of the grounding resistor according to the abnormal characteristics so as to adjust the transverse differential current value; the transverse differential current detection module 11 detects the transverse differential current value of a first direct-current switch of the pseudo-bipolar direct-current power distribution network, and the transverse differential current value is an absolute value of a difference between a positive pole current amplitude and a negative pole current amplitude of the direct-current switch; the transverse differential out-of-limit judgment module 12 generates a first transverse differential out-of-limit signal in response to a condition of the transverse differential current value being greater than a preset transverse differential out-of-limit threshold; the second transverse differential out-of-limit receiving module 13 receives second transverse differential out-of-limit signals of other protection apparatuses; and the internal fault protection module 14 determines that a fault of the first direct-current switch is an internal fault and performs fault protection in response to a condition that the first transverse differential out-of-limit signal has been generated and the second transverse differential out-of-limit signal of the subordinate direct-current switch of the first direct-current switch is not found.

Fig. 9 is a composition diagram of a protection system for a pseudo-bipolar direct-current power distribution network provided by an embodiment of this application. The protection system comprises a protection apparatus for a pseudo-bipolar direct-current power distribution network 1 and a platform for sharing data information 2.

The platform for sharing data information 2 communicates with a plurality of protection apparatuses 1, and sends and receives the transverse differential out-of-limit signal.

The platform for sharing data information 2 is a platform for interconnection and intercommunication between devices by using a unified standard protocol, and is used for transmitting information among the protection apparatuses therein. As a channel for information exchange between the protection apparatuses in the pseudo-bipolar direct-current power distribution network, the platform for sharing data information can transmit transverse differential protection starting signals judged by the protection apparatuses and tripping signals between the protection apparatuses in real time, which provides a reliable means for the application of transverse differential network protection. The platform can be realized by a process layer GOOSE network, a station control layer GOOSE network or a communication network.

It should be noted that the embodiments described above with reference to the drawings are only used to illustrate the application, but not to limit the scope of the application. Those of ordinarily skilled in the art should understand that modifications or equivalent substitutions made to the application without departing from the spirit and scope of the application should be covered within the scope of the application. In addition, unless otherwise specified in the context, words appearing in the singular form include the plural form, and vice versa. In addition, all or part of any embodiment can be used in combination with all or part of any other embodiment unless otherwise specified.

## Claims

1. A method for protecting a pseudo-bipolar direct-current power distribution network, comprising:
detecting a transverse differential current value of a first direct-current switch of the pseudo-bipolar direct-current power distribution network, the transverse differential current value being an absolute value of a difference between a positive pole current amplitude and a negative pole current amplitude of the first direct-current switch;
generating a first transverse differential out-of-limit signal in response to a condition of the transverse differential current value being greater than a preset transverse differential out-of-limit threshold;
detecting a second transverse differential out-of-limit signal of a subordinate direct-current switch of the first direct-current switch in the pseudo-bipolar direct-current power distribution network; and
determining that a fault of the first direct-current switch is an internal fault and performing fault protection in response to a condition that the first transverse differential out-of-limit signal has been generated and the second transverse differential out-of-limit signal of the subordinate direct-current switch of the first direct-current switch is not found.

2. The method according to claim 1, wherein after generating the first transverse differential out-of-limit signal in response to a condition of the transverse differential current value being greater than the preset transverse differential out-of-limit threshold, the method further comprises:
sending the first transverse differential out-of-limit signal to a direct-current switch protection apparatus adjacent to the first direct-current switch.

3. The method according to claim 2, wherein the sending the first transverse differential out-of-limit signal to the direct-current switch protection apparatus adjacent to the first direct-current switch, comprises:
sending the first transverse differential out-of-limit signal to the direct-current switch protection apparatus adjacent to the first direct-current switch through a platform for sharing data information.

4. The method according to claim 3, wherein the detecting the second transverse differential out-of-limit signal of the subordinate direct-current switch of the first direct-current switch in the pseudo-bipolar direct-current power distribution network, comprises:
receiving the second transverse differential out-of-limit signal of the subordinate direct-current switch of the first direct-current switch in the pseudo-bipolar direct-current power distribution network through the platform for sharing data information.

5. The method according to claim 1, wherein the preset transverse differential out-of-limit threshold is adjusted according to amplitude of a current flowing into the ground when a unipolar grounding fault occurs.

6. The method according to claim 5, wherein the preset transverse differential out-of-limit threshold is adjusted according to 0.6-0.8 times of the amplitude of the current flowing into the ground when a unipolar grounding fault occurs.

7. The method according to claim 1, further comprising:
adjusting a resistance value of a grounding resistor according to abnormal characteristics so as to adjust the transverse differential current value.

8. The method according to claim 7, wherein the abnormal characteristics comprises:
unbalanced positive and negative voltage amplitudes of the pseudo-bipolar direct-current power distribution network and/or an increased voltage to the ground at a valve side of a converter transformer of the pseudo-bipolar direct-current power distribution network when the unipolar grounding fault occurs.

9. The method according to claim 7, wherein the adjusting the resistance value of the grounding resistor according to the abnormal characteristics so as to adjust the transverse differential current value, comprises:
reducing the resistance value of the grounding resistor according to the abnormal characteristics and a structure of the grounding resistor so as to adjust the transverse differential current value.

10. The method according to claim 9, wherein the reducing the resistance value of the grounding resistor, comprises:
putting a small parallel resistor to the grounding resistor to reduce the resistance value of the grounding resistor.

11. The method according to claim 9, wherein the reducing the resistance value of the grounding resistor comprises:
turning on a lightning arrester connected in parallel with the grounding resistor to reduce the resistance value of the grounding resistor.

12. A protection apparatus for a pseudo-bipolar direct-current power distribution network, comprising:
a transverse differential current detection module for detecting a transverse differential current value of a first direct-current switch of the pseudo-bipolar direct-current distribution network, wherein the transverse differential current value is an absolute value of a difference between a positive pole current amplitude and a negative pole current amplitude of the first direct-current switch;
a transverse differential out-of-limit judgment module for generating a first transverse differential out-of-limit signal in response to a condition of transverse differential current value being greater than a preset transverse differential out-of-limit threshold;
a second transverse differential out-of-limit receiving module for detecting a second transverse differential out-of-limit signal of a subordinate direct-current switch of the first direct-current switch in the pseudo-bipolar direct-current power distribution network; and
an internal fault protection module for determining that a fault of the first direct-current switch is an internal fault and performing fault protection in response to a condition that the first transverse differential out-of-limit signal has been generated and the second transverse differential out-of-limit signal of the subordinate direct-current switch of the first direct-current switch is not found.

13. The protection apparatus according to claim 12, further comprising:
a grounding resistance adjusting module for adjusting a resistance value of a grounding resistor according to abnormal characteristics so as to adjust the transverse differential current value.

14. A protection system for a pseudo-bipolar direct-current power distribution network, comprising:
the protection apparatus according to claim 12 or claim 13, and
a platform for sharing data information communicating with a plurality of the protection apparatuses, and sends and receives the transverse difference out-of-limit signal.

15. An electronic device, comprising a memory, a processor and a computer program stored in the memory and capable of running on the processor, wherein when the program is executed by the processor, the processor is caused to execute the method according to any one of claims 1-11.

16. A computer-readable storage medium on which a computer program is stored, wherein the computer program, when executed by a processor, causes the processor to execute the method according to any one of claims 1-11.
